# EUROPEAN PATENT APPLICATION

(11) **EP 4 848 953 A1**
(43) Date of publication of application: **02.12.2026**
(21) Application number: 24920595.6
(22) Date of filing: 19.12.2024
(51) Int. Cl.: H10K 30/15, H10K 85/50, H10K 77/10, H10K 30/86, H10K 71/40, H10F 10/17, H10F 77/12

(54) **PEROVSKITE SOLUTION AND PEROVSKITE THIN FILM FORMING METHOD USING SAME**

(30) Priority: 25.01.2024 KR 20240011817
(71) Applicant: Hanwha Solutions Corporation, Jung-gu Seoul 04541 (KR)
(72) Inventor: CHOI, In Taek, Bucheon-si, Gyeonggi-do 14787 (KR); KIM, Song Hee, Yongin-si, Gyeonggi-do 16944 (KR)
(74) Representative: Mooser, Sebastian Thomas
(86) International application number: PCT/KR2024/020730
(87) International publication number: WO 2025/159346

(57) **Abstract**

An embodiment of the present invention can provide a perovskite solution comprising: a perovskite compound or a perovskite precursor compound; a compound represented by chemical formula 1; and water. [Chemical formula 1] RCOOH In chemical formula 1, R is hydrogen or a C₁-C₃ alkyl group.

## Description

### TECHNICAL FIELD

The present invention relates to a perovskite solution and to a method for forming a perovskite thin film using the same.

### BACKGROUND ART

In order to address the depletion of fossil energy and the global environmental problems caused by its use, research into renewable and clean alternative energy sources such as solar energy, wind power and hydropower is being actively conducted. Among these, interest in solar cells, which directly convert sunlight into electrical energy, has greatly increased. Here, a solar cell refers to a cell that generates current and voltage by utilizing the photovoltaic effect, in which light energy is absorbed from sunlight to generate electrons and holes.

At present, n-p diode-type silicon (Si) single-crystal-based solar cells having a light-to-energy conversion efficiency exceeding 20% can be manufactured and are being used in actual solar power generation. There are also solar cells using compound semiconductors such as gallium arsenide (GaAs), which exhibit even higher conversion efficiency. However, such inorganic-semiconductor-based solar cells require materials refined to very high purity in order to achieve high efficiency such that a large amount of energy is consumed in refining the raw materials. In addition, expensive process equipment is required in the process of forming single crystals or thin films from the raw materials such that there is a limit to lowering the manufacturing cost of the solar cells, which has been an obstacle to their large-scale utilization.

Accordingly, in order to manufacture solar cells at low cost, it is necessary to drastically reduce the cost of the materials or manufacturing processes that are used as the core of the solar cell. As an alternative to inorganic-semiconductor-based solar cells, research is being conducted into perovskite solar cells that can be manufactured using low-cost materials and processes.

Perovskite solar cells based on an organometallic halide compound having the molecular formula (CH₃NH₃)PbX₃ were first used as a photoactive material for solar cells in 2009. Subsequently, since the development of a solid-state perovskite solar cell having the current structure in 2012, efficiency improvements have been made rapidly. A typical perovskite solar cell uses a metal oxide as an electron transport layer, and mainly uses an organic material or a polymer material such as spiro-OMeTAD as a hole transport layer (HTL). That is, a metal oxide porous film or thin film is formed on a transparent electrode such as FTO and a perovskite solution is coated thereon, after which a hole transport layer is formed and then, an electrode layer such as gold (Au) or silver (Ag) is deposited.

Meanwhile, in order to prepare a perovskite solution, an anhydrous-type reagent is used as a solvent for dissolving the perovskite precursor. However, such a reagent is very expensive and difficult to handle. In addition, when a general mass-production solvent that is not of the anhydrous type is used, water (H₂O) may be incorporated as an impurity. When water is included, there is a problem in that the perovskite compound and/or the perovskite precursor is decomposed.

### DISCLOSURE

### TECHNICAL PROBLEM

One of various objects of the present invention is to provide a perovskite solution that does not use an anhydrous-type solvent, and a method for forming a perovskite thin film using the same.

One of various objects of the present invention is to provide a perovskite solution that enables manufacturing of a solar cell using a mass-production solvent, and a method for forming a perovskite thin film using the same.

One of various objects of the present invention is to provide a perovskite solution capable of suppressing the decomposition of a perovskite compound and/or a perovskite precursor, and a method for forming a perovskite thin film using the same.

### TECHNICAL SOLUTION

The present invention has been devised to solve the above problems, and the perovskite solution according to an embodiment of the present invention may include: a perovskite compound or a perovskite precursor compound; a compound represented by Chemical Formula 1 below; and water.

[Chemical Formula 1] RCOOH

In Chemical Formula 1, R is hydrogen or a C₁-C₃ alkyl group.

In an embodiment of the present invention, the perovskite compound may include a compound represented by Chemical Formula 2 below:

[Chemical Formula 2] ABX₃

wherein in Chemical Formula 2, A is formamidinium, methylammonium, cesium, rubidium, potassium, sodium, lithium, guanidinium, butylammonium, ethylammonium or phenethylammonium, B is lead, tin, germanium, cadmium, zinc or manganese, and X is iodide, bromide, chloride, fluoride, thiocyanate, cyanate, selenocyanate, formate or acetate.

In another embodiment of the present invention, the perovskite precursor compound may include one or more selected from formamidinium bromide (FABr), formamidinium iodide (FAI), methylammonium iodide (MAI), methylammonium bromide (MABr), methylammonium chloride (MACl) and an inorganic halogen compound.

In one example, the compound represented by Chemical Formula 1 may be HCOOH.

Meanwhile, the compound represented by Chemical Formula 1 may be included in a range of 0.5 vol% or more and/or 9.0 vol% or less, based on the total perovskite solution.

In addition, the water may be included in an amount of 50 ppm or more, based on the total perovskite solution.

In one example of the present invention, the perovskite solution according to the present invention may further include one or more solvents selected from dimethyl sulfoxide (DMSO), dimethylformamide (DMF), N-methylformamide (NMF), gamma-butyrolactone (GBL), N-methyl-2-pyrrolidone (NMP), N-cyclohexyl-2-pyrrolidone (CHP) and N,N-dimethylpropyleneurea (DMPU).

Another embodiment of the present invention may provide a method for forming a perovskite thin film, the method including: forming a hole transport layer on a transparent substrate; coating a perovskite solution on the hole transport layer; and heat-treating the perovskite solution, wherein the perovskite solution includes a perovskite compound, a compound represented by Chemical Formula 1 below, and water.

[Chemical Formula 1] RCOOH

In Chemical Formula 1, R is hydrogen or a C₁-C₃ alkyl group.

In this case, the compound represented by Chemical Formula 1 may be included in a range of 0.5 vol% or more and/or 9.0 vol% or less, based on the total perovskite solution.

In addition, the water may be included in an amount of 50 ppm or more, based on the total perovskite solution.

Meanwhile, the perovskite solution of the method for forming a perovskite thin film according to the present invention may further include one or more solvents selected from dimethyl sulfoxide (DMSO), dimethylformamide (DMF), N-methylformamide (NMF), gamma-butyrolactone (GBL), N-methyl-2-pyrrolidone (NMP), N-cyclohexyl-2-pyrrolidone (CHP) and N,N-dimethylpropyleneurea (DMPU).

### ADVANTAGEOUS EFFECTS

One of various effects of the present invention is that it is possible to provide a perovskite solution that does not use an anhydrous-type solvent, and a method for forming a perovskite thin film using the same.

One of various effects of the present invention is that it is possible to provide a perovskite solution that enables manufacturing of a solar cell using a mass-production solvent, and a method for forming a perovskite thin film using the same.

One of various effects of the present invention is that it is possible to provide a perovskite solution capable of suppressing the decomposition of a perovskite compound and/or a perovskite precursor, and a method for forming a perovskite thin film using the same.

However, various and beneficial advantages and effects of the present invention are not limited to the foregoing, and will be more readily understood in the course of describing specific embodiments of the present invention.

### DESCRIPTION OF DRAWINGS

FIG. 1 is an image photographing a perovskite solution prepared in the preparation example of the present invention.
FIG. 2 is a set of SEM images photographing perovskite thin films manufactured in the example and comparative examples of the present invention.
FIG. 3 is a graph showing XRD analysis results of perovskite thin films manufactured in the example and comparative examples of the present invention.

### MODES OF THE INVENTION

Hereinafter, embodiments of the present invention will be described with reference to specific embodiments and the accompanying drawings. This is not intended to limit the technology described in the present specification to particular embodiments, and it should be understood to include various modifications, equivalents and/or alternatives of the embodiments of the present invention. In connection with the description of the drawings, similar reference numerals may be used for similar components.

In the present specification, expressions such as "have", "may have", "include" or "may include" indicate the presence of the corresponding feature (e.g., a component such as a numerical value, function, operation or part) and do not exclude the presence of additional features.

In the present specification, expressions such as "A or B", "at least one of A and/or B" or "one or more of A and/or B" may include all possible combinations of the items listed together. For example, "A or B", "at least one of A and B" or "at least one of A or B" may refer to all of the cases of (1) including at least one A, (2) including at least one B, or (3) including both at least one A and at least one B.

The present invention relates to a perovskite solution. A perovskite solution according to one embodiment of the present invention may include a perovskite precursor or a perovskite compound; a compound represented by Chemical Formula 1 below; and water.

[Chemical Formula 1] RCOOH

In Chemical Formula 1, R is hydrogen or a C₁-C₃ alkyl group.

In one example, the perovskite compound of the perovskite solution according to the present invention may include a compound represented by Chemical Formula 2 below.

[Chemical Formula 2] ABX₃

In Chemical Formula 2, A is formamidinium, methylammonium, cesium, rubidium, potassium, sodium, lithium, guanidinium, butylammonium, ethylammonium or phenethylammonium, B is lead, tin, germanium, cadmium, zinc or manganese, and X is iodide, bromide, chloride, fluoride, thiocyanate, cyanate, selenocyanate, formate or acetate.

In another example, the perovskite precursor compound of the perovskite solution according to the present invention may include one or more selected from formamidinium bromide (FABr), formamidinium iodide (FAI), methylammonium iodide (MAI), methylammonium bromide (MABr), methylammonium chloride (MACl) and an inorganic halogen compound.

Perovskite compounds are characterized by a large absorption coefficient (strong solar absorption) and a low non-radiative carrier recombination rate. They are known to increase conversion efficiency owing to their high carrier mobility and the fact that defects that cause non-radiative carrier recombination are not formed within the band gap or at deep levels. When such a perovskite compound is applied to a solar cell, the manufacturing cost is low and a thin film can be fabricated by a solution process. Therefore, perovskite solar cells are currently attracting attention as next-generation thin-film solar cells.

In order to manufacture a perovskite solar cell by a solution process using the perovskite compound, there is a problem in that an anhydrous-type solvent, which is expensive and difficult to handle, must be used. A general mass-production-type solvent that is not of the anhydrous type may generally include water as an impurity. However, when water is included in the solvent for preparing the perovskite solution, a reaction as shown in Reaction Scheme 1 below may proceed.

[Reaction Scheme 1] 4CH₃NH₃PbI₃ + 4H₂O → 4[CH₃NH₃PbI₃·xH₂O] → (CH₃NH₃)₄PbI₆·2H₂O + 3PbI₂ + 2H₂O

When a mass-production solvent including water as an impurity is used as described above, such water may also cause a problem with respect to the perovskite precursor compound.

[Reaction Scheme 2] CH₃NH₃⁺ ↔ CH₃NH₂ + H⁺

In the above reaction scheme, since the pKa of methylammonium⁺ (MA⁺) is 10.6 and the pKa of H₂O is 14 to 15, MA⁺ acts as an acid when it is present together with water. Therefore, it can transfer H⁺ to the water, and accordingly, the perovskite A-site material may be decomposed by the water.

[Reaction Scheme 3] 4I⁻ + O₂ + 4H⁺ ↔ 2I₂ + H₂O [96] I⁻ + I₂ ↔ I₃⁻

In addition, the iodide anion included in the perovskite precursor may be decomposed and evaporated as shown in Reaction Scheme 3 above. This may generate cation defects during the formation of the perovskite thin film, thereby causing a problem of lowering the efficiency and stability of the solar cell.

The present invention is intended to solve these problems. Since the perovskite solution according to the present invention includes a compound represented by Chemical Formula 1, the decomposition of a perovskite compound due to impurities may be suppressed.

[Reaction Scheme 4] 4CH₃NH₃PbI₃ + 4CHOOH + 4H₂O → 4CH₃NH₃PbI₃ + 4CHOO⁻ + 4H₃O⁺

Reaction Scheme 4 above shows the mechanism by which the decomposition of a perovskite compound is suppressed when the compound represented by Chemical Formula 1 is added. As described above, there is a problem in that the perovskite compound being formed into the ABX₃ structure collapses into an ABX·xH₂O hydrate that is not of the ABX₃ structure. In this case, when the compound represented by Chemical Formula 1 is added, the compound represented by Chemical Formula 1 reacts with the water to form H₃O⁺, thereby suppressing the decomposition of a perovskite compound.

As in the case of the perovskite compound, the perovskite solution according to the present invention may prevent problems such as the occurrence of decomposition of the perovskite precursor by including the compound of Chemical Formula 1.

[Reaction Scheme 5] [110] HC(NH₂)₂⁺ ← C(NH₂)₂ + CHOOH CH₃NH₃⁺ ← CH₃NH₂⁺ + CHOOH

Reaction Scheme 5 above shows the mechanism by which the decomposition of a perovskite precursor is suppressed when the compound represented by Chemical Formula 1 is added. As described above, FAH⁺I⁻ and MAH⁺I⁻ may be deprotonated in the presence of moisture. In this case, when HCOOH (a carboxylic acid) is added as shown in Reaction Scheme 5, the forward reaction is suppressed, and the reverse reaction is induced. Through this, the compound represented by Chemical Formula 1 may suppress the decomposition of a perovskite precursor.

[Reaction Scheme 6] H⁺ + CO₂ + 2I⁻ ← I₂ + HCOO⁻ H⁺ + CO₂ + 3I⁻ ← I₃⁻ + HCOO⁻

In addition, when HCOOH is added to the perovskite solution, oxidized iodide may be reduced again as shown in Reaction Scheme 6 above, and oxidation may be suppressed.

In one example of the present invention, the compound represented by Chemical Formula 1 may be HCOOH. When the compound represented by Chemical Formula 1 is HCOOH, R in Chemical Formula 1 may be hydrogen.

In one example, the compound represented by Chemical Formula 1 of the perovskite solution according to the present invention may be included in a range of 0.5 vol% or more and/or 9.0 vol% or less, based on the total perovskite solution. When the content of the compound represented by Chemical Formula 1 is less than 0.5 vol% based on the total perovskite solution, it may not be possible to suppress the decomposition of a perovskite compound or a perovskite precursor compound due to moisture. When it is more than 9.0 vol%, the compound represented by Chemical Formula 1 may cause precipitation in the solution, which may make it difficult to apply the solution to a solution process for forming a perovskite thin film.

In another example, the water of the perovskite solution according to the present invention may be included in an amount of 50 ppm or more based on the total perovskite solution. The water may be introduced as an impurity during the process of preparing the perovskite solution, and specifically may be included in the mass-production-type solvent. The content of the water may be, for example, 50 ppm or more, 70 ppm or more, 90 ppm or more, 110 ppm or more, 130 ppm or more, or 150 ppm or more. The upper limit is not particularly limited, but may be, for example, 2,000 ppm or less, 1,900 ppm or less, or 1,800 ppm or less.

In one example of the present invention, the perovskite solution according to the present invention may further include one or more solvents selected from dimethyl sulfoxide (DMSO), dimethylformamide (DMF), N-methylformamide (NMF), gamma-butyrolactone (GBL), N-methyl-2-pyrrolidone (NMP), N-cyclohexyl-2-pyrrolidone (CHP) and N,N-dimethylpropyleneurea (DMPU).

As described above, the solvent may not be an anhydrous-type solvent, but may be a mass-production-type solvent. The criterion for distinguishing between an anhydrous-type solvent and a mass-production-type solvent may be based on the water content of the solvent. For example, a solvent having a moisture content of less than 50 ppm may be classified as an anhydrous-type solvent. In addition, a solvent having a moisture content of 50 ppm or more, 70 ppm or more, 90 ppm or more, 110 ppm or more, 130 ppm or more, or 150 ppm or more may be classified as a mass-production-type solvent. By using a mass-production-type solvent, the perovskite solution according to the present invention may increase the production efficiency of a perovskite solar cell.

The present invention also relates to a method for forming a perovskite thin film. Another embodiment of the present invention may provide a method for forming a perovskite thin film, the method including: forming a hole transport layer on a transparent substrate; coating a perovskite solution on the hole transport layer; and heat-treating the perovskite solution, wherein the perovskite solution includes a perovskite compound, a compound represented by the following Chemical Formula 1, and water.

[Chemical Formula 1] RCOOH

In Chemical Formula 1, R is hydrogen or a C₁-C₃ alkyl group.

In this case, the compound represented by Chemical Formula 1 may be included in a range of 0.5 vol% or more and/or 9.0 vol% or less, based on the total perovskite solution.

In addition, the water may be included in an amount of 50 ppm or more, based on the total perovskite solution.

Meanwhile, the perovskite solution of the method for forming a perovskite thin film according to the present invention may further include one or more solvents selected from dimethyl sulfoxide (DMSO), dimethylformamide (DMF), N-methylformamide (NMF), gamma-butyrolactone (GBL), N-methyl-2-pyrrolidone (NMP), N-cyclohexyl-2-pyrrolidone (CHP) and N,N-dimethylpropyleneurea (DMPU).

Since the descriptions of the compound represented by Chemical Formula 1, the water, the solvent and the like are the same as those described above, they will be omitted.

Hereinafter, preferred examples are presented to aid understanding of the present invention. However, the following examples are provided merely to facilitate easier understanding of the present invention, and the content of the present invention is not limited by the following examples.

### Preparation Example

A perovskite solution was prepared using a mass-production DMF solvent rather than a reagent-grade anhydrous solvent. The perovskite solution was prepared by mixing precursors of a perovskite compound represented by ABX (where A is an inorganic precursor such as CsX and/or an organic precursor such as FAX, B is Pb metal, and X is a halide (I, Br, Cl)). As the compound represented by Chemical Formula 1, HCOOH was added to the perovskite solution at 3 v/v%.

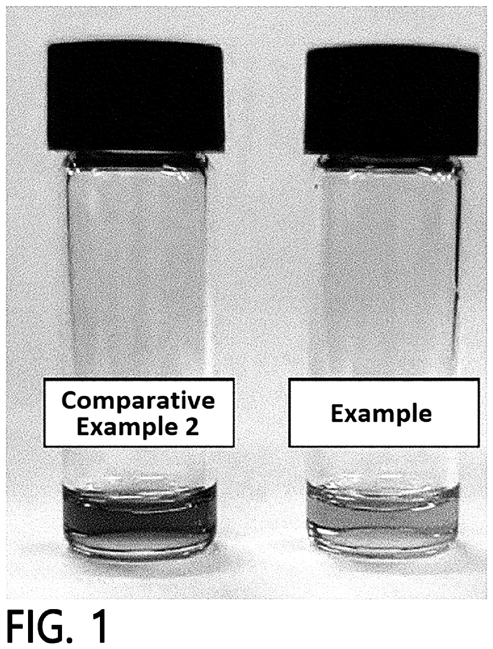

FIG. 1 shows the state of the perovskite solution prepared in the preparation example and the mass-production solvent after being stored for two weeks. Referring to FIG. 1, it can be confirmed that the mass-production solvent to which no additive was added exhibited a more intense yellow color than the perovskite solution prepared in the preparation example of the present invention. This is because, as can be confirmed in Reaction Schemes 1 to 3, I₂ or I₃⁻ is generated by the water included in the mass-production solvent. In contrast, in the case of the perovskite solution prepared in the preparation example of the present invention, since the generation of I₂ or I₃⁻ is suppressed, it can be seen that the color of the solution hardly changed even after two weeks had elapsed from its preparation.

### Example

As the bottom solar cell, a crystalline silicon solar cell including a first doping layer on a p-type silicon substrate was used.

A first electrode (ITO) having an average thickness of 20 nm was formed on the silicon solar cell substrate by physical vapor deposition. NiOₓ was deposited on the first electrode by a vacuum deposition method, and 200 µL of Me-4PACz [4-(3,6-dimethyl-9H-carbazol-9-yl)butyl]phosphonic acid was dropped onto the NiOₓ, followed by spin coating at 3,000 rpm for 30 seconds and heat treatment at 100°C to form a hole transport layer having an average thickness of 20 nm.

Thereafter, 100 µL of a 1.3 M perovskite precursor solution having a composition of Cs_{0.2}FA_{0.8}Pb(I_{0.8}Br_{0.2})₃ prepared in the preparation example was dropped, and after spin coating at 5,000 rpm for 30 seconds under a nitrogen atmosphere, heat treatment was performed at 100°C for 20 minutes to form a perovskite thin film having a final thickness of 700 nm.

A C60 layer having a thickness of 13 nm was formed as an electron transport layer on the perovskite thin film, and a 10 nm SnO₂ layer serving both as ETL and buffer was deposited on the formed electron transport layer by an ALD process. Thereafter, a top TCO layer of 70 nm was formed by physical vapor deposition, and a second electrode (Ag) was formed to a thickness of 200 nm using thermal evaporation equipment, thereby manufacturing a perovskite/silicon tandem photoelectric conversion device.

### Comparative Example 1

A tandem device was manufactured in the same manner as in the Example, except that a reagent-grade anhydrous solvent rather than the mass-production-type solvent was used in the Preparation Example and HCOOH was not added.

### Comparative Example 2

A tandem device was manufactured in the same manner as in the Example, except that HCOOH was not added to the mass-production solvent used in the preparation example.

### Experimental Example 1

The moisture content of the reagent-grade anhydrous DMF solvent and the mass-production DMF solvent was measured by the Karl Fischer coulometric titration method, and the results are shown in Table 1 below. Specifically, a reagent solution for moisture measurement containing iodide ions is electrolyzed to generate iodine, and the moisture content can be measured from the amount of electricity consumed in the electrolysis by utilizing the fact that the iodine reacts quantitatively with the water. As shown in Formula (1) below, since iodine reacts with water, both coulometric titration and volumetric titration are possible.

I₂ + SO₂ + 3Base + ROH + H₂O ⇒ 2Base·HI + Base·HSO₄R ··· (1)

**[Table 1]**

| | 1st Measurement | 2nd Measurement | Average |
|---|---|---|---|
| Reagent-grade Anhydrous Solvent | 45.1 ppm | 50.9 ppm | 48 ppm |
| Mass-production Solvent | 356.8 ppm | 352.6 ppm | 354.7 ppm |

Referring to Table 1, the reagent-grade anhydrous DMF solvent exhibited an average moisture content of 48 ppm, whereas the mass-production solvent exhibited an average of 354.7 ppm. It can thus be confirmed that the mass-production solvent includes moisture at a concentration approximately seven times or higher than that of the anhydrous-type solvent.

### Experimental Example 2

The performance of each of the tandem solar cells manufactured in the Example and Comparative Examples 1 and 2 was measured, and the results are shown in Table 2 below. Specifically, the efficiency of the solar cells was measured using a solar simulator and a JV Keithley instrument based on the initial JV curve.

**[Table 2]**

| Classification | Bottom Cell | Open-circuit Voltage (Voc) | Short-circuit Current Density (Jsc) | Fill Factor (FF) | Power Conversion Efficiency (Eff.) |
|---|---|---|---|---|---|
| | | [V] | [mA/cm²] | [%] | [%] |
| Comparative Example 1 | | 1.845 | 20.25 | 75.85 | 28.34 |
| | | 1.833 | 20.25 | 71.86 | 26.67 |
| Comparative Example 2 | Si-PERC | 1.910 | 16.08 | 70.89 | 21.77 |
| | | 1.861 | 15.84 | 47.95 | 14.13 |
| Example | | 1.890 | 19.93 | 78.37 | 29.52 |
| | | 1.875 | 19.89 | 73.91 | 27.56 |

Referring to Table 2, it can be confirmed that the electrical performance of the tandem solar cell manufactured in the Example of the present invention was very excellent. In particular, with respect to the open-circuit voltage, fill factor and power conversion efficiency, the tandem solar cell manufactured in the Example of the present invention had performance equivalent to that of Comparative Example 1, which used a reagent-grade anhydrous solvent. In contrast, in the case of Comparative Example 2, even though the same mass-production solvent as in the Example was used, the performance of the tandem solar cell of Comparative Example 2 was significantly degraded compared to the Example. Through this, it can be seen that the perovskite solution according to the present invention has a very excellent effect even with a mass-production solvent by including the compound represented by Chemical Formula 1.

### Experimental Example 3

The components of the perovskite thin films manufactured in the Example and Comparative Example 1 were analyzed by X-ray photoelectron spectroscopy (XPS) and ultraviolet photoelectron spectroscopy (UPS) using an AXIS Supra instrument, and the results are shown in Table 3 below.

**[Table 3]**

| | WF | VBM | IE | O | C | Cs | N | Pb | I | Br | Cl | N/C1 |
|---|---|---|---|---|---|---|---|---|---|---|---|---|
| Comparative Example 1 | 5.29 | 0.52 | 5.81 | 1.0 | 17.3 | 2.6 | 22.3 | 15.5 | 33.9 | 7.5 | 0.0 | 2.1 |
| Example | 5.41 | 0.64 | 6.05 | 0.9 | 18.0 | 2.1 | 19.6 | 16.6 | 35.5 | 7.3 | 0.0 | 1.8 |

Referring to Table 3, it can be confirmed that the I content of the perovskite thin film manufactured in the Example of the present invention was higher than the I content of the perovskite thin film of Comparative Example 1. As described above, even an anhydrous-type solvent includes a small amount of water as an impurity, which becomes a cause of a side reaction that decomposes I.

Through the results of Reaction Scheme 2, due to the moisture included in the anhydrous-type solvent, the H⁺ at the A-site was decomposed and the I⁻ ions bonded thereto were decomposed together, and accordingly, through the results of Reaction Scheme 3, the I content of the perovskite thin film of Comparative Example 1 decreased due to the trace amount of moisture included in the anhydrous-type solvent. In contrast, the Example of the present invention, to which the compound represented by Chemical Formula 1 was added, suppresses such decomposition, and therefore has the effect of having an even higher I content than Comparative Example 1, which used an anhydrous-type solvent.

### Experimental Example 4

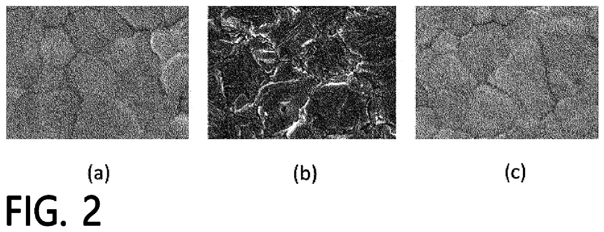

FIG. 2 shows images of the perovskite thin films manufactured in Comparative Examples 1 and 2 and the Example, taken with a field emission scanning electron microscope (FE-SEM, JSM-7900F, JEOL). FIG. 2(a) shows Comparative Example 1, FIG. 2(b) shows Comparative Example 2, and FIG. 2(c) shows the Example. Referring to FIG. 2, it can be seen that the perovskite thin film of Comparative Example 2, which used a mass-production solvent, had a non-uniform grain size and a very rough surface state compared to Comparative Example 1, which used an anhydrous-type solvent. In contrast, in the case of the perovskite thin film manufactured in the Example of the present invention, it can be confirmed that it had a grain size uniformity and surface roughness similar to those of Comparative Example 1, which used an anhydrous solvent.

### Experimental Example 5

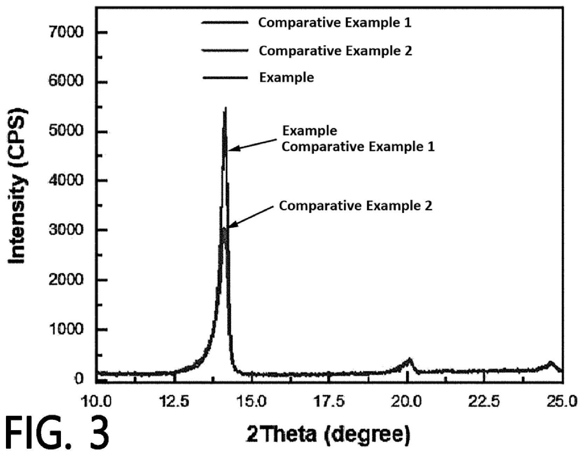

FIG. 3 shows the results of measuring the crystallinity of the perovskite thin films manufactured in the Example, Comparative Example 1 and Comparative Example 2 using X-ray diffraction (XRD, D8 ADVANCE, BRUKER). Referring to FIG. 3, in the case of Comparative Example 2, to which a mass-production solvent was applied, it can be seen that the peak at 2-theta 14.1°, which represents the perovskite crystallinity, was significantly lowered. In contrast, in the case of the perovskite thin film manufactured in the Example of the present invention, it can be confirmed that it exhibited a peak of almost the same magnitude as Comparative Example 1, which used an anhydrous solvent. Therefore, the perovskite solution according to the present invention may maintain a high level of perovskite crystallinity even while using a mass-production solvent, by including the compound represented by Chemical Formula 1.

Although the embodiments of the present invention have been described in detail above, the present invention is not limited by the above-described embodiments and the accompanying drawings, but is intended to be limited by the appended claims. Therefore, various substitutions, modifications and changes may be made by those of ordinary skill in the art within a range that does not depart from the technical idea of the present invention described in the claims, and these also fall within the scope of the present invention.

## Claims

1. A perovskite solution, comprising:
a perovskite compound or a perovskite precursor compound;
a compound represented by Chemical Formula 1 below; and
water,
[Chemical Formula 1] RCOOH
wherein in Chemical Formula 1, R is hydrogen or a C₁-C₃ alkyl group.

2. The perovskite solution of claim 1, wherein the perovskite compound comprises a compound represented by Chemical Formula 2 below:
[Chemical Formula 2] ABX₃
wherein in Chemical Formula 2, A is formamidinium, methylammonium, cesium, rubidium, potassium, sodium, lithium, guanidinium, butylammonium, ethylammonium or phenethylammonium, B is lead, tin, germanium, cadmium, zinc or manganese, and X is iodide, bromide, chloride, fluoride, thiocyanate, cyanate, selenocyanate, formate or acetate.

3. The perovskite solution of claim 1, wherein the perovskite precursor compound comprises one or more selected from formamidinium bromide (FABr), formamidinium iodide (FAI), methylammonium iodide (MAI), methylammonium bromide (MABr), methylammonium chloride (MACl) and an inorganic halogen compound.

4. The perovskite solution of claim 1, wherein the compound represented by Chemical Formula 1 is HCOOH.

5. The perovskite solution of claim 1, wherein the compound represented by Chemical Formula 1 is comprised in a range of 0.5 vol% or more and/or 9.0 vol% or less, based on the total perovskite solution.

6. The perovskite solution of claim 1, wherein the water is comprised in an amount of 50 ppm or more, based on the total perovskite solution.

7. The perovskite solution of claim 1, further comprising one or more solvents selected from dimethyl sulfoxide (DMSO), dimethylformamide (DMF), N-methylformamide (NMF), gamma-butyrolactone (GBL), N-methyl-2-pyrrolidone (NMP), N-cyclohexyl-2-pyrrolidone (CHP) and N,N-dimethylpropyleneurea (DMPU).

8. A method for forming a perovskite thin film, the method comprising:
forming a hole transport layer on a transparent substrate;
coating a perovskite solution on the hole transport layer; and
heat-treating the perovskite solution,
wherein the perovskite solution comprises a perovskite compound, a compound represented by Chemical Formula 1 below, and water:
[Chemical Formula 1] RCOOH
wherein in Chemical Formula 1, R is hydrogen or a C₁-C₃ alkyl group.

9. The method of claim 8, wherein the compound represented by Chemical Formula 1 is comprised in a range of 0.5 vol% or more and/or 9.0 vol% or less, based on the total perovskite solution.

10. The method of claim 8, wherein the water is comprised in an amount of 50 ppm or more, based on the total perovskite solution.

11. The method of claim 8, wherein the perovskite solution further comprises one or more solvents selected from dimethyl sulfoxide (DMSO), dimethylformamide (DMF), N-methylformamide (NMF), gamma-butyrolactone (GBL), N-methyl-2-pyrrolidone (NMP), N-cyclohexyl-2-pyrrolidone (CHP) and N,N-dimethylpropyleneurea (DMPU).
